# FASCICULE DE BREVET EUROPEEN

(11) **EP 1 925 079 B1**
(45) Date de publication et mention de la délivrance du brevet: **23.12.2009**
(21) Numéro de dépôt: 06763533.4
(22) Date de dépôt: 06.06.2006
(51) Int. Cl.: H03K 17/12

(54) **COMMUTATEUR DE COURANT A PAIRE DIFFERENTIELLE DE TRANSISTORS ALIMENTE PAR UNE FAIBLE TENSION VCC**
STROMSCHALTER MIT DURCH EINE NIEDERSPANNUNG GESPEISTEN DIFFERENZTRANSISTORPAAREN
CURRENT SWITCH WITH DIFFERENTIAL TRANSISTOR PAIRS FED BY A LOW VOLTAGE

(30) Priorité: 28.06.2005 FR 0506563
(43) Date de publication de la demande: 28.05.2008
(73) Titulaire: E2V Semiconductors, 38521 Saint Egreve (FR)
(72) Inventeur: MORISSON, Richard, F-38000 Grenoble (FR)
(74) Mandataire: Guérin, Michel
(86) Numéro de dépôt international: PCT/EP2006/062935
(87) Numéro de publication internationale: WO 2007/000387

(56) Documents cités:
- EP-A- 0 620 638
- US-A1- 2003 141 924
- US-A1- 2005 068 066
- PATENT ABSTRACTS OF JAPAN vol. 013, no. 248 (E-770), 9 juin 1989 (1989-06-09) & JP 01 049317 A (PIONEER ELECTRONIC CORP; others: 01), 23 février 1989 (1989-02-23)
- SUMANEN L ET AL: "A 10-bit high-speed low-power CMOS D/A converter in 0.2 mm<2>" ELECTRONICS, CIRCUITS AND SYSTEMS, 1998 IEEE INTERNATIONAL CONFERENCE ON LISBOA, PORTUGAL 7-10 SEPT. 1998, PISCATAWAY, NJ, USA,IEEE, US, vol. 1, 7 septembre 1998 (1998-09-07), pages 15-18, XP010366161 ISBN: 0-7803-5008-1

## Description

L'invention concerne les circuits intégrés logiques et analogiques, et notamment ceux qui utilisent des sources de tension d'alimentation de très faible valeur (inférieures ou égales à 3 volts).

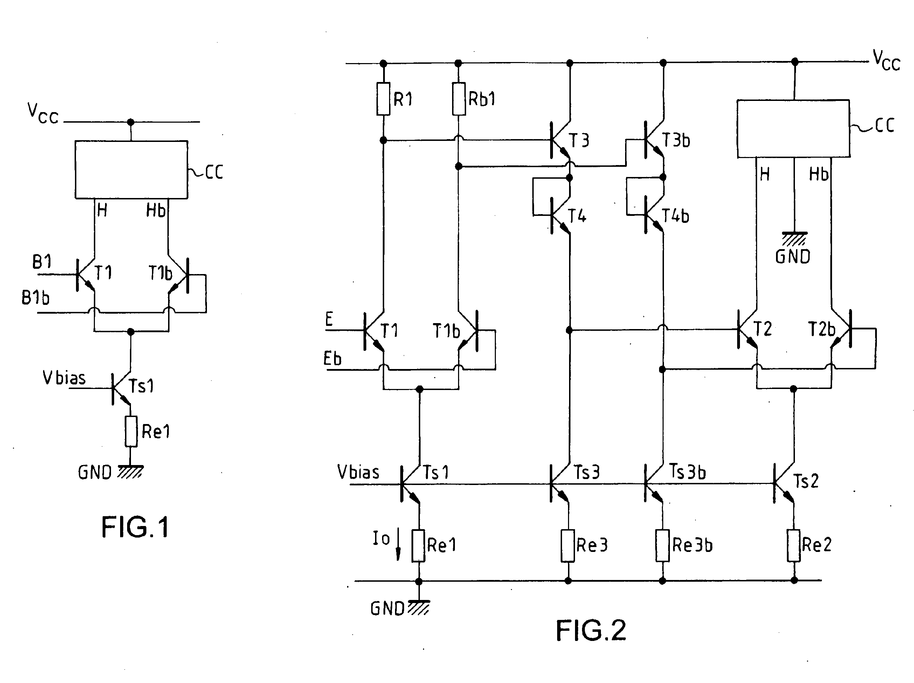

Dans de nombreuses applications, on veut commander un circuit logique ou analogique en tout ou rien par une paire de courants de commande fonctionnant en différentiel ; pour cela on est amené à utiliser un commutateur de courant sous forme d'une paire de transistors T1 et T1b en deux branches parallèles alimentées par une source de courant constant commune conformément au schéma de la figure 1. La source de courant est en général constituée par un transistor NPN Ts1 et sa résistance d'émetteur Re1, la base de ce transistor étant commandée par une tension de polarisation constante Vbias. Les transistors T1 et T1b ont leurs émetteurs réunis et connectés tous deux à cette source de courant ; ils sont commandés par leurs bases B1 et B1b, en différentiel, un niveau de tension haut étant appliqué sur la base de l'un des transistors pendant qu'un niveau bas est appliqué sur la base de l'autre. Le courant de la source de courant passe dans celui des transistors dont la base est au niveau haut. Les collecteurs des transistors servent à alimenter en courant, en différentiel, deux entrées de commande complémentaires H et Hb d'un circuit logique ou analogique CC. Le fonctionnement du circuit CC est défini par le choix de l'entrée qui reçoit du courant, donc par le signe de la tension différentielle appliquée entre les bases B1 et B1b des transistors. Les entrées de commande du circuit logique ou analogique peuvent être tout simplement des entrées d'horloge complémentaires faisant passer le circuit alternativement d'un état dans un autre. Par exemple, si le circuit est un échantillonneur bloqueur, l'horloge fait passer le circuit alternativement d'un mode échantillonnage (H au niveau haut, Hb au niveau bas) à un mode blocage (Hb au niveau haut, H au niveau bas).

Dans ce qui suit on appellera paire différentielle de transistors l'ensemble de deux transistors ayant leurs émetteurs réunis et leurs bases commandées par deux signaux logiques complémentaires.

On utilisera ici l'appellation base, émetteur et collecteur de transistor en se référant à des transistors bipolaires comme à la figure 1. Les explications sont les mêmes pour des transistors MOS en remplaçant les appellations base, émetteur et collecteur par grille, source et drain ; on se contentera donc, pour simplifier, de donner les explications à propos de transistors bipolaires, sans que l'invention soit limitée aux technologies bipolaires, et les appellations base, émetteur et collecteur seront considérées comme génériques dans cette demande de brevet.

Des étages de commutation de courant sous forme de paires différentielles peuvent être utilisés en cascade dans les circuits intégrés, notamment lorsqu'on a besoin d'un courant relativement important en sortie alors qu'on ne veut pas charger excessivement la sortie d'un étage situé en amont. Une difficulté se présente cependant lorsque les tensions d'alimentation sont faibles car les niveaux autour desquelles varient les tensions de commande des bases ne peuvent pas être choisis n'importe comment ; le niveau haut et le niveau bas doivent être suffisamment différents pour que la paire différentielle bascule franchement d'un état dans l'autre ; et leur niveau moyen doit être ni trop haut ni trop bas. S'il est trop bas, les transistors ne peuvent pas être rendus conducteurs et la source de courant constant qui alimente en général les deux transistors n'est pas polarisée correctement ; s'il est trop haut les sorties de la paire différentielle sont à un niveau trop haut pour permettre de commander efficacement le circuit logique ou analogique, ceci pour des raisons de saturation. Comme la sortie d'une paire différentielle est nécessairement à un niveau de tension plus haut que l'entrée (en ce qui concerne l'état haut de sortie), il peut par ailleurs être nécessaire de prévoir des étages de transposition de niveau entre deux paires différentielles en cascade pour abaisser le niveau de tension de sortie avant d'attaquer un étage en aval. Ceci est d'autant plus nécessaire si le circuit à commander exige, pour son fonctionnement correct, que les entrées H et Hb restent à un niveau de tension relativement bas.

On s'aperçoit alors que les différentes contraintes de fonctionnement des commutateurs de courant constitués par des paires différentielles cascadées impliquent
- ou bien qu'on soit obligé d'utiliser une tension d'alimentation Vcc plus haute que ce qu'on souhaite (et ceci est critique pour des circuits alimentés par des piles à faible tension comme c'est très souvent le cas dans des appareils portables),
- ou bien qu'on ne puisse pas avoir en sortie du commutateur des valeurs de tension suffisamment basses pour commander correctement le circuit qu'on veut commander.

La figure 2 représente un exemple typique d'utilisation de paires différentielles cascadées dans un circuit de commande de la technique antérieure. Il utilise deux paires différentielles T1, T1b et T2, T2b.

La première paire différentielle constitue l'entrée du circuit de commutation de courant ; elle comporte deux transistors T1 et T1b et les émetteurs de ces transistors sont reliés à une source de courant constant constituée par un transistor Ts1 et sa résistance d'émetteur Re1, la base de ce transistor étant reliée à une tension de polarisation Vbias. La source de courant fournit un courant constant Io, contrôlé en température, de préférence un courant indépendant de la température dans la gamme d'utilisation du circuit. Les collecteurs des transistors T1 et T1b sont reliés à des résistances de collecteur respectives R1 et Rb1. Les bases des transistors de la première paire sont reliées aux deux entrées E et Eb du circuit commutateur de courant. Les sorties de la première paire différentielle sont prélevées sur les collecteurs des transistors T1 et T1b.

Le circuit analogique ou logique à commander est encore désigné par le bloc CC de la figure 2. Ce peut être un échantillonneur-bloqueur, un multiplieur, ou un multiplexeur, par exemple. Il est alimenté entre la source d'énergie à tension Vcc et la masse GND. Il possède deux entrées de commande logique complémentaires en courant H et Hb. Ces entrées de commande sont constituées par les sorties de la deuxième paire différentielle T2, T2b, et ces sorties sont les collecteurs des transistors T2 et T2b. La deuxième paire est alimentée en courant par une source de courant constituée par un transistor Ts2 et sa résistance d'émetteur Re2, la base du transistor Ts2 recevant la même tension de polarisation constante Vbias. La source de courant Ts2 fournit un courant Io ou proportionnel à Io. Dans ce qui suit on considérera qu'il s'agit d'un courant Io pour simplifier, mais il est bien connu qu'avec la même tension de polarisation Vbias on peut produire dans Ts2 un courant k.Io dès lors que la surface effective d'émetteur de Ts2 est k fois celle de Ts1 et dès lors que la résistance d'émetteur Re2 est k fois plus faible que Re1.

C'est en appliquant des signaux complémentaires alternés sur les entrées E et Eb qu'on fait commuter les entrées H et Hb qui contrôlent le circuit à commander CC.

Pour cela, les sorties de la première paire différentielle sont connectées directement ou indirectement aux entrées de la première paire. Ici un étage de transposition de niveau est prévu entre les deux paires pour abaisser le niveau des tensions de sortie de la première paire avant de les appliquer aux entrées de la deuxième. Les sorties de cet étage de transposition sont appliquées aux bases des transistors T2 et T2b.

L'étage de transposition de niveau dans cet ensemble est constitué de deux branches identiques, l'une interposée entre une première sortie (collecteur de T1) de la première paire et une première entrée (base de T2) de la deuxième paire, l'autre interposée entre une deuxième sortie (collecteur de T1b) de la première paire et une deuxième entrée (base de T2b) de la deuxième paire. Chaque branche de l'étage de transposition comporte ici trois transistors en série, T3, T4 et Ts3 et une résistance d'émetteur Re3 pour la première branche ; T3b, T4b, Ts3b et Re3b pour la deuxième branche. Le transistor T3 a son collecteur à Vcc, son émetteur relié au collecteur de T4, et sa base reliée à la sortie de la première paire différentielle (sortie prise sur le collecteur de T1). Le transistor T4 est monté en diode (collecteur relié à sa base), son émetteur est relié au collecteur de Ts3 et son collecteur est relié à l'émetteur de T4. Enfin, le transistor Ts3 a son émetteur relié, par l'intermédiaire de la résistance Re3 à la masse, et sa base alimentée par le potentiel de polarisation Vbias. Les dimensions du transistor Ts3 et de la résistance Re3 sont calculées pour que cette source fournisse un courant Io ou un courant dans un rapport de proportionnalité choisi avec Io. L'émetteur du transistor T4 monté en diode constitue une sortie de l'étage de cette branche de l'étage de transposition et il est relié à la base du transistor T2 de la deuxième paire différentielle. Cet étage abaisse d'une valeur de tension base-émetteur Vbe de transistor (typiquement environ 0,8 volt) les potentiels de sortie de la première paire différentielle avant de les appliquer à la deuxième paire. Si on voulait abaisser le niveau de 2Vbe, ou 3Vbe, on intercalerait d'autres transistors montés en diode entre T4 et Ts3.

L'autre branche de l'étage de transposition est identique et reliée à entre le collecteur du transistor T1b et la base du transistor T2b.

La constitution de ce circuit impose une valeur minimale de la tension Vcc pour un fonctionnement correct du circuit. Cette valeur minimale dépend essentiellement des chutes de tension introduite par les tensions base-émetteur des différents transistors qu'on trouve dans le circuit.

Il est souhaitable de rechercher des circuits permettant d'utiliser une tension d'alimentation Vcc plus basse que celle que permettent les circuits de l'art antérieur (sans dégradation de la rapidité de commutation).

Pour cela, l'invention propose un commutateur de courant comportant deux paires différentielles de deux transistors chacune, ces paires étant disposées en cascade, la deuxième paire ayant des sorties complémentaires en courant dont l'une fournit du courant pendant que l'autre est bloquée et réciproquement selon l'état d'un signal différentiel appliqué entre les bases des deux transistors de la première paire, la première paire étant reliée à une masse par une source de courant constant de valeur Io, cette source comprenant un transistor dont la base est maintenue à une tension de polarisation Vbias, **caractérisé en ce que** d'une part la deuxième paire différentielle est reliée à la masse directement par une résistance et en ce que d'autre part la première paire différentielle est alimentée par une tension égale à N.Vbe+Vbias, où N est un nombre entier (de préférence égal à 1), et Vbe est la tension de base-émetteur du transistor de la source de courant fournissant le courant Io.

De cette disposition, il résulte, comme on le verra en détail plus loin, qu'on peut appliquer à la base d'un transistor de la deuxième paire différentielle une tension égale à Vbias qui le rend conducteur (conduisant un courant Io ou proportionnel à Io) ; ainsi, la base des transistors de la deuxième paire peut recevoir une tension de commande de niveau plus faible que dans l'art antérieur (en général plutôt Vbias+Vbe dans l'art antérieur) , d'où il résulte qu'on peut alimenter l'ensemble du circuit avec une tension d'alimentation générale Vcc plus faible que celle qui était exigée dans l'art antérieur.

La première paire différentielle est de préférence alimentée en tension par un transistor d'alimentation placé en série entre une source de tension d'alimentation générale Vcc et la paire différentielle, le transistor d'alimentation ayant sa base commandée par un noeud de jonction entre une source de courant à faible chute de tension reliée à la tension d'alimentation Vcc et un ensemble en série, relié à la masse, de plusieurs transistors montés en diodes et une résistance, la tension Vbias étant prélevée sur la base d'un des transistors montés en diode.

La base de ce transistor d'alimentation reçoit ainsi une tension égale à Vbias+(N+1)Vbe et l'émetteur de ce transistor fournit à la première paire différentielle une tension Vbias+N.Vbe.

La source de courant est de préférence régulée en température et/ou en alimentation ; c'est de préférence une source de type bandgap ; elle utilise en principe des transistors PNP ou PMOS.

Dans une autre réalisation, ne nécessitant pas de transistor PNP ou PMOS et donc utilisable dans des technologies rapides ne comportant que des transistors bipolaires NPN, la première paire différentielle est alimentée par la tension d'alimentation générale Vcc à travers une simple résistance ; cette résistance est parcourue par un courant (en principe 2Io) tel que la chute de tension à ses bornes soit égale à Vcc-(Vbias+N.Vbe), et pour cela cette résistance est placée en série avec un transistor NPN ou NMOS qui dérive vers la masse un courant d'émetteur déterminé (en principe lo).

Dans une autre variante encore, une source de courant de Wilson, régulée en température sert à fournir à la fois une tension de polarisation Vbias et une tension d'alimentation égale à Vbias+N.Vbe.

On notera que les publications de brevet US 2005/0068066 et US 2003/01411924 décrivent des commutateurs de courant utilisant des paires différentielles.

D'autres caractéristiques et avantages de l'invention apparaîtront à la lecture de la description détaillée qui suit et qui est faite en référence aux dessins annexés dans lesquels :
- les figures 1 et 2, déjà décrites, représentent des circuits commutateurs de courant de l'art antérieur ;
- la figure 3 représente le circuit selon l'invention dans une première réalisation ;
- la figure 4 représente un exemple de source de courant de type bandgap utilisable dans la première réalisation de l'invention.
- la figure 5 représente une deuxième variante de réalisation du commutateur de courant selon l'invention ;
- la figure 6 représente une source de tension de référence n'utilisant pas de transistor PMOS ou PNP et permettant d'établir une tension d'alimentation de la première paire différentielle ;
- la figure 7 représente une source de tension et courant permettant d'établir à la fois une tension Vbias et une tension Vbias+N.Vbe.

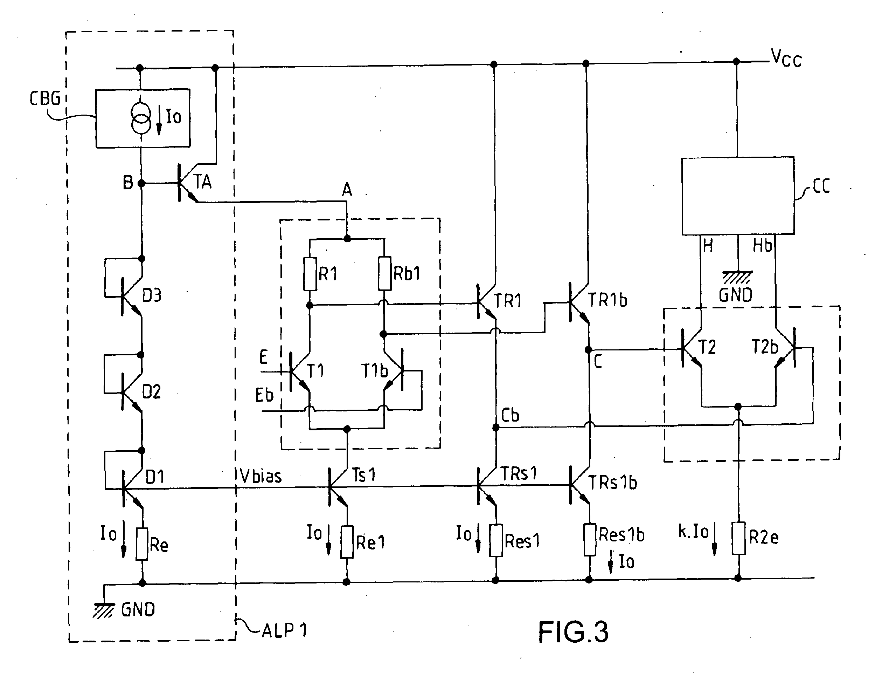

Sur la figure 3, la fonction électronique à commander, analogique ou numérique, est encore désignée par CC, alimentée entre Vcc et la masse et commandée par les entrées complémentaires H et Hb qui sont en même temps les sorties complémentaires d'un commutateur en courant selon l'invention.

A titre d'exemple on suppose que le circuit CC est un échantillonneur bloqueur et que la commande en courant destinée aux bornes H et Hb est une commande par une horloge dont les sorties en courant complémentaires sont alternées pour faire passer alternativement l'échantillonneur bloqueur d'un mode d'échantillonnage à un mode de blocage.

Le commutateur de courant comprend tout d'abord les éléments principaux suivants :
- une première paire différentielle de deux transistors T1, T1b dont les entrées E et Eb reçoivent des signaux de commande complémentaires ;
- une deuxième paire différentielle de deux transistors T2, T2b dont les sorties sont connectées aux bornes de commande en courant H et Hb du circuit CC, et dont les entrées sont connectées aux sorties de la première paire différentielle, directement ou par l'intermédiaire d'un étage de transposition de niveau (sur la figure 3, il y a un étage de transposition de niveau) ;
- un circuit ALP1 d'alimentation en tension de la première paire différentielle T1, T1b, cette dernière n'étant pas alimentée directement par la tension d'alimentation générale Vcc.

La première paire différentielle comporte deux transistors identiques T1 et T1b ; ils sont reliés par leurs émetteurs à une source de courant constant placée en série entre ces émetteurs et la masse GND ; la source fournit un courant Io ; la première paire comporte également des résistances de collecteur R1 et Rb1, identiques, entre le collecteur de chaque transistor et un point commun A qui est la sortie du circuit d'alimentation en tension ALP1. Les bases des transistors T1 et T1b sont reliées aux entrées E et Eb du circuit.

La source de courant de cette paire T1, T1b est constituée par un transistor Ts1 en série avec une résistance d'émetteur Re1 ; la base du transistor Ts1 est commandée par une tension de polarisation fixe Vbias ; la tension Vbias est choisie d'une manière classique en fonction des dimensions du transistor, de la valeur de la résistance Re1 et de la valeur du courant Io désiré dans la première paire. Les dimensions des transistors T1, T1b et Ts1 sont en principe identiques.

Les sorties de la première paire T1, T1b, sont prises sur les collecteurs des transistors T1 et T1b.

Dans l'exemple de la figure 3, qui est un exemple préféré pour des circuits rapides (horloge pouvant atteindre plusieurs gigahertz), on a inséré un étage de transposition de niveau entre les sorties de la première paire différentielle et les entrées de la deuxième paire. L'étage de transposition a pour fonction d'abaisser le niveau de potentiel des sorties de la première paire avant de l'appliquer aux entrées de la deuxième paire.

L'étage de transposition comprend, pour chaque sortie de la paire T1, T1b associée à une entrée respective de la paire T2, T2b, un demi-étage suiveur respectif. Le demi-étage suiveur comprend un transistor suiveur TR1 (ou TR1b pour l'autre demi-étage) en série avec une source de courant respective. La source de courant est constituée par un transistor TRs1 (ou TRs1b) et une résistance d'émetteur Res1 ou Res1b. La base de ce transistor reçoit la même tension Vbias que les autres sources de courant du schéma. Les dimensions des transistors TR1, TR1b, TRs1, TRs1b sont en principe identiques. Les transistors TRs1 et TRs1b sont par ailleurs identiques au transistor Ts1, et les résistances Res1 et Res1b sont identiques à la résistance Re1. Cependant, classiquement, il est possible de prévoir que les différentes sources de courant ont des dimensions de transistor qui sont proportionnelles et non pas identiques les unes aux autres, le rapport de proportionnalité réglant classiquement le rapport entre les courants dans les différentes branches (les résistances sont alors inversement proportionnelles aux dimensions des transistors). De cette manière, si les transistors sont parcourus par les courants nominaux qui doivent les parcourir (Io pour Ts1 et pour T1 ou T1b, ou un courant proportionnel à Io pour TRs1 et pour TR1 ou TR1b), alors les tensions émetteur-base de tous ces transistors ont une même valeur Vbe. Sur la figure 3 on a fait l'hypothèse simplificatrice que les transistors des différentes sources de courant sont tous parcourus par le courant Io.

Le transistor suiveur TR1 du premier demi-étagé suiveur a son collecteur relié à l'alimentation générale Vcc, son émetteur relié à la source de courant TRs1 et à la base du transistor T2b (qui constitue une entrée de la deuxième paire différentielle). Le transistor suiveur TR1b du deuxième demi-étage a son collecteur relié à l'alimentation générale Vcc, son émetteur relié à la source de courant TRs1b et à la base du transistor T2 (qui constitue une autre entrée de la deuxième paire différentielle).

La deuxième paire différentielle n'est pas alimentée classiquement par une source de courant constant qui serait constituée par un transistor polarisé par la tension Vbias avec une résistance d'émetteur Re de même valeur que les autres. Ici, selon l'invention, les émetteurs des transistors T2 et T2b de la deuxième paire sont reliés à la masse par l'intermédiaire d'une simple résistance R2e. Mais on s'arrange pour que cette résistance soit parcourue par le même courant Io que les sources de courant déjà mentionnées. Ou plus exactement on s'arrange pour qu'elle soit parcourue par le courant Io si les transistors T2 et T2b ont la même taille que le transistor Ts1 ou bien par un courant k.Io si les transistors T2 et T2b sont k fois plus gros que le transistor Ts1. La taille des transistors considérée ici est la surface effective d'émetteur car c'est elle qui règle la relation entre la tension base-émetteur et le courant d'émetteur.

Pour faire en sorte que la résistance Re2 soit parcourue par un courant k.Io, on donne à la résistance Re2 la valeur Re1/k.

Il en résulte que pour autoriser le passage d'un courant k.Io dans le transistor T2, l'autre transistor T2b étant bloqué, il faut appliquer sur sa base (noeud C sur la figure 3) une tension égale à k.Io.Re2 + Vbe. Or cette tension n'est pas autre chose que Io.Re1 + Vbe puisque Re2=Re1/k, et elle n'est pas autre chose que Vbias puisque Vbias est la somme d'une tension Vbe du transistor Ts1 et de la chute de tension dans Re1.

Il faut donc appliquer Vbias sur les noeuds C ou Cb pour rendre conducteurs le transistor T2 ou le transistor T2b avec un courant k.Io désiré. Si on décide que l'état haut est celui pour lequel T2 est conducteur, on a un état haut lorsque le transistor T1b est bloqué et le transistor T1 est conducteur.

Pour appliquer Vbias sur le noeud C (par exemple) dans l'état haut, on constate qu'il faut avoir Vbias+Vbe sur le collecteur de T1b lorsque celui-ci est bloqué. Or lorsque T1b est bloqué, son collecteur est porté à la tension d'alimentation de la première paire différentielle T1, T1b, c'est-à-dire au potentiel du noeud A représenté sur la figure 3, le noeud A étant la sortie du circuit ALP1 d'alimentation en tension de la première paire différentielle.

On fait donc en sorte selon l'invention d'appliquer à la première paire différentielle une tension Vbias+Vbe.

Cependant, cette tension Vbias+Vbe est calculé en tenant compte du fait que l'étage de transposition de niveau effectue une transposition égale à Vbe. On pourrait ne pas avoir d'étage de transposition de niveau ou avoir un étage de transposition effectuant une transposition de N.Vbe, N étant un nombre entier de quelques unités.

Par conséquent, plus généralement, on appliquera à la première paire différentielle une tension d'alimentation égale à Vbias+N.Vbe.

Le circuit de commutation de courant selon l'invention a donc deux particularités : la deuxième paire différentielle est reliée à la masse par une simple résistance et la première paire différentielle est alimentée par une tension Vbias+N.Vbe, où Vbias est la tension de polarisation d'un transistor qui a Vbe pour tension base-émetteur et qui constitue une source de courant pour la première paire.

Dans la réalisation représentée à la figure 3, le circuit d'alimentation en tension ALP1 qui alimente la première paire différentielle T1, T1b comporte les éléments suivants :
- un ensemble d'un transistor D1 monté en diode (collecteur et base réunis) et d'une résistance d'émetteur Re, parcourus par un courant fixé Io (si le transistor D1 est identique à Ts1 et la résistance Re est égale à Re1) ou proportionnel à Io (si le transistor D1 est dans un rapport de proportionnalité avec Ts1 et la résistance Re dans le rapport inverse avec Re1) ; la résistance Re est reliée à la masse GND et alors il apparaît sur la base de D1 la tension Vbias désirée, qui est appliquée aux transistors Ts1, TRs1 et TRs1b ; ceci suppose bien sûr qu'on sache imposer un courant désiré Io dans le transistor D1 ;
- N+1 transistors (ici N=1) D2, D3, montés en diode, identiques au transistor D1, en série avec le transistor D1 et la résistance Re, l'ensemble Re, D1, D2, D3, parcouru par le courant Io (ou proportionnel à Io) étant en série entre la masse GND et un noeud B sur lequel apparaît alors une tension Vbias+(N+1).Vbe
- une source de courant CBG régulée en température, imposant un courant Io (ou proportionnel à Io) à l'ensemble en série raccordé au noeud B ; la constitution de cette source de courant est choisie pour présenter la plus faible chute de tension possible entre l'alimentation générale Vcc et le noeud B ; la chute de tension est par exemple de l'ordre de 200 mV ; sa faible valeur, associée à la valeur de tension Vbias+(N+1)Vbe présente sur le noeud B, garantit la faible valeur de Vcc (pour un nombre entier N donné). A titre d'exemple numérique, si N=1, si la tension Vbias est d'environ 0,9 volts, Vcc peut être d'environ 2,7 volts ;
- un transistor d'alimentation TA identique à Ts1, dont la base est connectée au point B, dont le collecteur est relié à Vcc et dont l'émetteur est relié au noeud d'alimentation A de la première paire différentielle T1, T1b.

De préférence, la source de courant CBG est un circuit dit "circuit bandgap en courant" CBG qui a pour fonction de produire un courant sortant choisi, contrôlé en fonction de la température (en principe indépendant de la température et de l'alimentation).

Le circuit de bandgap en courant peut être constitué de différentes manières, à partir de circuits de bandgap en tension de type connus, c'est-à-dire des circuits qui fournissent une tension contrôlée en fonction de la température, en général une tension aussi indépendante que possible de la température. Ces circuits, aptes à établir un courant sortant, nécessitent en général au moins un transistor PMOS ou PNP. En résumé, les circuits de bandgap, bien connus, sont des sources de courant ou tension qui reposent sur une relation connue, de forme exponentielle, entre le courant parcouru par un transistor à tension base-émetteur donnée et surface de transistor donnée, et la température. Ces circuits reposent sur un équilibre de courants et tensions, indépendant de la température (le plus souvent) ou contrôlé en fonction de la température, dans des branches comprenant des transistors dont les actions se compensent lors de variations de température.

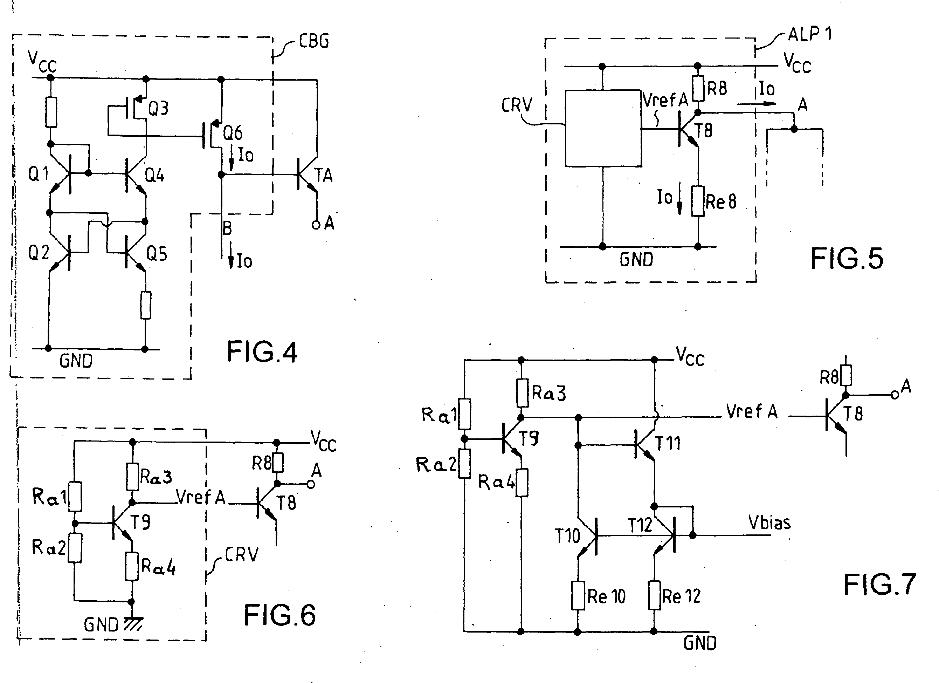

La figure 4 représente un exemple de circuit de bandgap en courant fournissant un courant sortant sur le noeud B auquel est reliée par ailleurs la base du transistor TA. Ce circuit comporte six transistors et deux résistances, répartis en trois branches. La première branche comprend en série entre l'alimentation Vcc et la masse, dans l'ordre, une résistance de collecteur, un transistor NPN Q1 monté en diode (collecteur relié à la base) et ayant son collecteur relié à la résistance de collecteur, et un transistor NPN Q2 dont le collecteur est relié à l'émetteur de Q1 et dont l'émetteur est relié à la masse. La deuxième branche comprend, en série entre Vcc et la masse, dans l'ordre, un transistor PMOS Q3 monté en diode (drain relié à la grille) et ayant sa source reliée à Vcc, un transistor NPN Q4 ayant son collecteur relié au drain de Q3, un transistor NPN Q5 ayant son collecteur relié à l'émetteur de Q4 et son émetteur relié par une résistance d'émetteur à la masse. La base de Q1 est reliée à la base de Q4 ; la base de Q2 est reliée à l'émetteur de Q4. La base de Q5 est reliée à l'émetteur de Q1. La troisième branche comprend un transistor PMOS Q6 monté en miroir de courant par rapport à Q3, c'est-à-dire que ces deux transistors ont leurs sources reliées toutes deux à Vcc, et leurs grilles reliées l'une à l'autre. Le drain de Q6 fournit un courant constant Io contrôlé en fonction de la température et pouvant être indépendant de la température ; la valeur de ce courant est déterminée par les dimensions des transistors, la valeur des résistances, et la valeur de Vcc. Ce courant constant sert de source d'alimentation des transistors en série D1, D2, D3 de la figure 3. Ce courant est fourni sur une sortie B avec une très faible chute de tension (environ 200 mV ou moins) par rapport à Vcc.

A partir du point B de la figure 3, on alimente en tension la base du transistor TA. Une chute de tension base-émetteur Vbe est introduite entre le point B et le point A qui alimente la première paire différentielle T1, T1b. Cette chute de tension est la même valeur Vbe que les autres tensions base-émetteur du circuit car le transistor TA est identique à Ts1 et est parcouru par le même courant que Ts1.

La tension au noeud A est donc Vbias+N.Vbe, ce que l'on voulait.

Le circuit de bandgap en courant pourrait utiliser des transistors PNP à la place des transistors PMOS.

Si on ne dispose ni de transistors PNP ni de transistor PMOS dans la technologie utilisée, on peut utiliser une réalisation différente pour le circuit l'alimentation ALP1 de la paire différentielle T1, T1b.

La figure 5 représente un exemple de cette réalisation différente : le circuit d'alimentation ALP1 comprend un ensemble en série d'une résistance de collecteur R8, un transistor NPN T8 et une résistance d'émetteur Re8, l'ensemble étant placé entre l'alimentation Vcc et la masse. La base du transistor T8 est alimentée par une tension issue d'un circuit de référence de tension CRV capable de produire une tension VrefA d'une valeur quelconque désirée. La particularité du circuit de référence de tension CRV est qu'il fournit une tension VrefA ayant cette valeur indépendamment de la valeur de l'alimentation Vcc. Le transistor T8 est identique au transistor Ts1 (ou, on le répète ici, dans un rapport de proportionnalité connu, mais on fera l'hypothèse d'une identité pour simplifier) et on s'arrange pour qu'il soit parcouru par le même courant Io.

Ce circuit d'alimentation ALP1 alimente la première paire différentielle de la même manière qu'à la figure 3, et le commutateur de courant comprend les mêmes éléments qu'à la figure 3 : étages de transposition et deuxième paire différentielle, non représentés sur la figure 5.

On sait calculer la résistance de collecteur R8 en fonction de Vcc pour que la tension au noeud A soit Vbias+N.Vbe :

### 2.Io.RB=Vcc-Vbias-N.Vbe.

Si on veut que Vcc soit petit il faut que la chute de tension dans la résistante soit petite, par exemple 200 millivolts, et R8 doit être choisie en conséquence.

La résistance Re8 est choisie de manière à établir à ses bornes une chute de tension qui peut être approximativement Vbias +(N-1).Vbe pour un courant Io. Cela détermine Re8. La tension VrefA à appliquer à la base de T8 peut en être déduite (VrefA = Vbias + N.Vbe) et on construit le circuit CRV capable de fournir cette tension VrefA.

Typiquement, uns tel circuit de référence de tension CRV est représenté à la figure 6. Il comprend quatre résistances et un transistor T9 et les rapports entre les valeurs des résistances permettent d'obtenir cette valeur de tension de référence pour une valeur de Vbias et N donnée. Les résistances et leurs valeurs sont désignées par Ra1, Ra2, Ra3, et Ra4. Les résistances Ra1 et Ra2 sont montées en pont diviseur entre Vcc et la masse et la base du transistor est alimentée par la prise intermédiaire du pont diviseur. La résistance Ra3 est une résistance d'émetteur du transistor T9, et elle est reliée à la masse. La résistance Ra4 est une résistance de collecteur et elle est reliée à Vcc. Si on simplifie en écrivant que VrefA=N'.Vbe, alors le rapport Ra3/Ra4 doit être égal à N', de même que le rapport (Ra1+Ra2)/Ra2.

La tension VrefA ainsi réalisée, indépendante de la valeur de Vcc, permet d'établir un courant bien défini dans le transistor T8 du circuit ALP1 et donc une chute de tension faible et contrôlée dans la résistance R8 sans recourir à des transistors PMOS ou NMOS.

Le circuit de la figure 6 peut-être complété de manière à fournir non seulement cette tension de référence VrefA mais aussi la tension Vbias elle-même qu'on désire pour alimenter la première paire différentielle (qui dans le cas de la figure 3 était fournie par le collecteur du transistor D1). Pour cela, on ajoute au circuit de la figure 6 des éléments supplémentaires comme cela est représenté à la figure 7.

Ces éléments supplémentaires comprennent :
- un transistor NPN T10 ayant son collecteur recevant la tension VrefA, son émetteur relié à la masse à travers une résistance d'émetteur Re10,
- un transistor NPN T11 ayant son collecteur relié à Vcc, sa base reliée au collecteur de T10 (donc à VrefA)
- au moins un transistor T12 monté en diode, ayant son émetteur relié à la masse à travers une résistance d'émetteur Re12, son collecteur et sa base reliés à la base de T10, la tension apparaissant sur ce noeud étant la tension Vbias qui sert à commander toutes les bases de transistors constituant les sources de courant de valeur Io ou proportionnelles à Io du circuit de commutation de courant,
- éventuellement d'autres transistors montés en diode, en série entre le collecteur de T12 et l'émetteur de T11 ; le nombre total de transistors montés en diode en série est N.

On a ainsi décrit plusieurs réalisations permettant, grâce au principe de l'invention, de réduire autant que possible la tension d'alimentation générale Vcc nécessaire à un fonctionnement correct du commutateur de courant. On rappelle, comme on l'a dit précédemment que tous les transistors NPN du circuit pourraient être remplacés par des transistors NMOS.

## Revendications

1. Commutateur de courant comportant deux paires différentielles de deux transistors chacune (T1, T1b ; T2, T2b), ces paires étant disposées en cascade, la deuxième paire (T2, T2b) ayant des sorties complémentaires en courant (H, Hb) dont l'une fournit du courant pendant que l'autre est bloquée et réciproquement selon l'état d'un signal différentiel appliqué entre les bases (E, Eb) des deux transistors de la première paire, la première paire (T1, T1b) étant reliée à une masse (GND) par une source de courant constant de valeur Io, cette source (Ts1, Re1 comprenant un transistor (Ts1) dont la base est maintenue à une tension de polarisation Vbias, **caractérisé en ce que** d'une part la deuxième paire différentielle (T2, T2b) est reliée à la masse directement par une résistance (R2e), et **en ce que** d'autre part la première paire différentielle est alimentée par une tension égale à N.Vbe+Vbias, où N est un nombre entier, et Vbe est la tension de base-émetteur du transistor (Ts1) de la source de courant fournissant le courant Io.

2. Commutateur de courant selon la revendication 1, **caractérisé en ce que** la première paire différentielle (T1, T1b) est alimentée en tension par un transistor d'alimentation (TA) placé en série entre une source de tension d'alimentation générale Vcc et la paire différentielle, le transistor d'alimentation ayant sa base commandée par un noeud de jonction (B) entre une source de courant à faible chute de tension (CBG) reliée à la tension d'alimentation Vcc et un ensemble en série, relié à la masse, de plusieurs transistors montés en diodes (D1, D2, D3) et une résistance (Re), la tension Vbias étant prélevée sur la base d'un des transistors (D1) montés en diode.

3. Commutateur de courant selon la revendication 2, **caractérisé en ce que** la source de courant à faible chute de tension (CBG) est une source de type bandgap, fournissant un courant régulé en température.

4. Commutateur de courant selon l'une des revendications 1 à 3, **caractérisé en ce que** N est égal à 1.

5. Commutateur de courant selon la revendication 1, **caractérisé en ce que** la première paire différentielle est alimentée par la tension d'alimentation générale Vcc à travers une simple résistance de collecteur (R8) de valeur (Vcc-NVbe-Vbias)/2Io connectée d'un côté à la paire et au collecteur d'un transistor (T8) et de l'autre à la tension d'alimentation Vcc, et **en ce que** ce transistor (T8) a sa base alimentée par un circuit de référence de tension (CRV) produisant une tension de référence VrefA égale à Vbias+(NVbe) et a son émetteur relié à une résistance d'émetteur (Re8) de valeur égale à [Vbias+(N-1)Vbe]/lo où Io est le courant d'alimentation de la première paire différentielle.

6. Commutateur de courant selon la revendication 5, **caractérisé en ce que** Ile circuit de référence de tension (CRV) comporte deux sorties, l'une établissant la tension VrefA et l'autre établissant la tension de polarisation Vbias.

## Claims

1. Current switch including two differential pairs of two transistors each (T1, T1b; T2, T2b), these pairs being arranged in cascade form, the second pair (T2, T2b) having complementary current outputs (H, Hb), one of which supplies current while the other is blocked and vice versa depending on the state of a differential signal applied between the bases (E, Eb) of the two transistors of the first pair, the first pair (T1, T1b) being connected to a ground (GND) through a constant current source supplying a current of value lo, this source (Ts1, Re1) comprising a transistor (Ts1), the base of which is held at a bias voltage Vbias, **characterized in that** on the one hand the second differential pair (T2, T2b) is connected to ground directly through a resistance (R2e), and **in that** on the other hand the first differential pair is supplied by a voltage equal to N.Vbe+Vbias, where N is a whole number, and Vbe is the base-emitter voltage of the transistor (Ts1) of the current source supplying the current Io.

2. Current switch according to Claim 1,
**characterized in that** the first differential pair (T1, T1b) has voltage supplied by a supply transistor (TA) placed in series between a main supply voltage source Vcc and the differential pair, the supply transistor having its base controlled by a junction node (B) between a low-voltage-drop current source (CBG) connected to the supply voltage Vcc and a series-connected group, connected to ground, of several transistors mounted as diodes (D1, D2, D3) and a resistance (Re), the voltage Vbias being taken at the base of one of the transistors (D1) mounted as a diode.

3. Current switch according to Claim 2,
**characterized in that** the low-voltage-drop current source (CBG) is a bandgap type source supplying a temperature-regulated current.

4. Current switch according to one of Claims 1 to 3, **characterized in that** N is equal to 1.

5. Current switch according to Claim 1,
**characterized in that** the first differential pair is supplied by the main supply voltage Vcc through a simple collector resistance (R8) of value (Vcc-NVbe-Vbias)2Io connected on one side to the pair and to the collector of a transistor (T8) and on the other side to the supply voltage Vcc and **in that** this transistor (T8) has its base supplied via a voltage reference circuit (CRV) producing a reference voltage VrefA equal to Vbias+(NVbe) and has its emitter connected to an emitter resistance (Re8) of value equal to [Vbias+(N-1)Vbe]/Io, where Io is the supply current for the first differential pair.

6. Current switch according to Claim 5,
**characterized in that** the voltage reference circuit (CRV) has two outputs, one establishing the voltage VrefA and the other establishing the bias voltage Vbias.

## Patentansprüche

1. Stromschalter, der zwei differentielle Paare von je zwei Transistoren (T1, T1b; T2, T2b) aufweist, wobei diese Paare in Kaskade angeordnet sind, wobei das zweite Paar (T2, T2b) komplementäre Stromausgänge (H, Hb) hat, von denen einer Strom liefert, während der andere blockiert ist und umgekehrt, je nach dem Zustand eines differentiellen Signals, das zwischen den Basen (E, Eb) der zwei Transistoren des ersten Paars angelegt wird, wobei das erste Paar (T1, T1b) über eine Konstantstromquelle des Werts Io mit einer Masse (GND) verbunden ist, wobei diese Quelle (Ts1, Re1) einen Transistor (Ts1) enthält, dessen Basis auf einer Vorspannung Vbias gehalten wird, **dadurch gekennzeichnet, dass** einerseits das zweite differentielle Paar (T2, T2b) direkt über einen Widerstand (R2e) mit Masse verbunden ist, und dass andererseits das erste differentielle Paar mit einer Spannung gleich N.Vbe+Vbias gespeist wird, wobei N eine ganze Zahl und Vbe die Basis-Emitter-Spannung des Transistors (Ts1) der Stromquelle ist, die den Strom Io liefert.

2. Stromschalter nach Anspruch 1, **dadurch gekennzeichnet, dass** das erste differentielle Paar (T1, T1b) von einem Speisetransistor (TA) mit Spannung gespeist wird, der in Reihe zwischen einer allgemeinen Speisespannungsquelle Vcc und dem differentiellen Paar geschaltet ist, wobei die Basis des Speisetransistors von einem Verbindungsknoten (B) zwischen einer Stromquelle mit schwachem Spannungsabfall (CBG), die mit der Speisespannung Vcc verbunden ist, und einer in Reihe geschalteten, an Masse gelegten Einheit von mehreren als Dioden geschalteten Transistoren (D1, D2, D3) und einem Widerstand (Re) gesteuert wird, wobei die Spannung Vbias am der Basis eines der als Diode geschalteter Transistoren (D1) abgenommen wird.

3. Stromschalter nach Anspruch 2, **dadurch gekennzeichnet, dass** die Stromquelle mit schwachem Spannungsabfall (CBG) eine Quelle vom Typ Bandgap ist, die einen temperaturgeregelten Strom liefert.

4. Stromschalter nach einem der Ansprüche 1 bis 3, **dadurch gekennzeichnet, dass** N gleich 1 ist.

5. Stromschalter nach Anspruch 1, **dadurch gekennzeichnet, dass** das erste differentielle Paar mit der allgemeinen Speisespannung Vcc über einen einfachen Kollektorwiderstand (R8) des Werts (Vcc-NVbe-Vbias)2Io gespeist wird, der einerseits mit dem Paar und mit dem Kollektor eines Transistors (T8) und andererseits mit der Speisespannung Vcc verbunden ist, und dass die Basis dieses Transistors (T8) von einer Spannungsreferenzschaltung (CRV) gespeist wird, die eine Referenzspannung VrefA gleich Vbias+(NVbe) erzeugt, und sein Emitter mit einem Emitterwiderstand (Re8) eines Werts gleich [Vbias+(N-1)Vbe]Io verbunden ist, wobei Io der Speisestrom des ersten differentiellen Paars ist.

6. Stromschalter nach Anspruch 5, **dadurch gekennzeichnet, dass** die Spannungsreferenzschaltung (CRV) zwei Ausgänge aufweist, von denen der eine die Spannung VrefA aufbaut und der andere die Vorspannung Vbias aufbaut.
